(19) Europäisches Patentamt European Patent Office Office européen des brevets

(11) **EP 2 979 074 B1**

(12) **EUROPEAN PATENT SPECIFICATION**

(45) Date of publication and mention
of the grant of the patent:
**17.07.2019 Bulletin 2019/29**

(21) Application number: **13880135.2**

(22) Date of filing: **29.03.2013**

(51) Int Cl.:
**G01M 17/02** (2006.01)

(86) International application number:
**PCT/US2013/034600**

(87) International publication number:
**WO 2014/158185 (02.10.2014 Gazette 2014/40)**

(54) **TIRE UNIFORMITY ESTIMATION USING ESTIMATES BASED ON CONVOLUTION/DECONVOLUTION**

SCHÄTZUNG DER REIFENGLEICHFÖRMIGKEIT ANHAND VON SCHÄTZUNGEN AUF BASIS VON FALTUNG/ENTFALTUNG

ESTIMATION DE L'UNIFORMITÉ DE PNEUMATIQUES À L'AIDE D'ESTIMATIONS BASÉES SUR UNE CONVOLUTION/DÉCONVOLUTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.02.2016 Bulletin 2016/05**

(73) Proprietor: **Compagnie Générale des Etablissements Michelin 63000 Clermont-Ferrand (FR)**

(72) Inventors:
• **MAWBY, William, David Greenville, SC 29605 (US)**
• **TRAYLOR, James, Michael Greenville, SC 29605 (US)**

(74) Representative: **Casalonga Casalonga & Partners Bayerstraße 71/73 80335 München (DE)**

(56) References cited:
EP-A1- 1 435 516          WO-A1-2006/055649
WO-A1-2011/159272          WO-A1-2012/074527
US-A- 5 421 197          US-A- 6 139 401
US-A1- 2005 262 933          US-A1- 2007 084 541
US-A1- 2007 144 657          US-A1- 2011 246 128

• **PARKER ET AL.: 'Tire Uniformity Tester for Automotive Service Industry.' 2000, XP055281818 Retrieved from the Internet: <URL:http://www.gsp9700.com/technical/4693t /4693t.htm> [retrieved on 2013-06-17]**
• **SCHWARZ ET AL.: 'Developing a Learning Progression for Scientific Modeling: Making Scientific Modeling Accessible and Meaningful for Learners.' JOURNAL OF RESEARCH IN SCIENCE TEACHING. vol. 46, 2009, pages 632 - 654, XP055279586 Retrieved from the Internet: <URL:http://deepblue.lib.umich.edu/bitstrea m/handle/2027.42/63556/20311_ftp.pdf?sequen ce=1> [retrieved on 2013-06-17]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE INVENTION**

The present disclosure relates generally to systems and methods for improving tire uniformity, and more particularly to systems and methods for improving tire uniformity based on the use of convolution/deconvolution-based estimates of uniformity parameters.

**BACKGROUND OF THE INVENTION**

Tire non-uniformity relates to the symmetry (or lack of symmetry) relative to the tire's axis of rotation in certain quantifiable characteristics of a tire. Conventional tire building methods unfortunately have many opportunities for producing non-uniformities in tires. During rotation of the tires, non-uniformities present in the tire structure produce periodically-varying forces at the wheel axis. Tire non-uniformities are important when these force variations are transmitted as noticeable vibrations to the vehicle and vehicle occupants. These forces are transmitted through the suspension of the vehicle and may be felt in the seats and steering wheel of the vehicle or transmitted as noise in the passenger compartment. The amount of vibration transmitted to the vehicle occupants has been categorized as the "ride comfort" or "comfort" of the tires.

Tire uniformity parameters, or attributes, are generally categorized as dimensional or geometric variations (radial run out and lateral run out), mass variance, and rolling force variations (radial force variation, lateral force variation and tangential force variation, sometimes also called longitudinal or fore and aft force variation). Once tire uniformity parameters are identified, correction procedures can be performed to account for some of the uniformities by making adjustments to the manufacturing process. Additional correction procedures can be performed to address non-uniformities of a cured tire including, but not limited to, the addition and/or removal of material to a cured tire and/or deformation of a cured tire.

Force variation parameters of a tire, such as radial force variation, can be attributable not only to the geometric variations (e.g. radial run out) of the tire but also to variations in tire stiffness. In certain circumstances, it can be desirable to determine the portion of a measured force variation parameter attributable to geometric variations in the tire and the portion of the measured force variation parameter attributable to tire stiffness. In addition, only certain tire uniformity parameter measurements may be available for a tire. For instance, radial run out measurements may be available for a tire but radial force variation measurements may not be available.

In EP1435516 radial force variation at a target speed is predicted based on the measured radial force variation at a lower speed and radial run out measured at the target speed. WO2011/159272 and WO2012/074527 disclose similar methods.

Thus, a need exists for a system and method for estimating radial force variation for a tire based on measurements of radial run out and vice versa. A system and method that can provide for assessing the stiffness of a tire would be particularly useful.

**SUMMARY OF THE INVENTION**

Aspects and advantages of the invention will be set forth in part in the following description, or may be apparent from the description, or may be learned through practice of the invention.

One exemplary aspect of the present disclosure is directed to a method for estimating the uniformity of a tire according to claim 1. The method includes obtaining a measured radial uniformity parameter (e.g. measured radial run out or measured radial force variation) for a plurality of measurement points about a tire. The method further includes accessing a model correlating radial run out of the tire with radial force variation of the tire, the model correlating an estimated radial uniformity parameter for a discrete measurement point as a weighted sum of the measured radial uniformity parameter at the discrete measurement point and one or more selected measurement points proximate the discrete measurement point, and determining, with a computing device, an estimated radial uniformity parameter (e.g. estimated radial run out or estimated radial force) for at least one discrete measurement point for the tire using the model. The estimated radial uniformity parameter for the at least one discrete measurement point can be determined based at least in part on the measured radial uniformity parameter for one or more measurement points (e.g. along a center track or along a plurality of tracks) proximate to the discrete measurement point on the tire. In a particular implementation, the one or more measurement points proximate to the discrete measurement point can be identified based on a contact patch length of the tire.

Another exemplary aspect of the present disclosure is directed to a system for estimating a uniformity parameter of a tire according to claim 15. The system includes a measurement machine configured to acquire a measured radial uniformity parameter for a plurality of measurement points about a tire. The system further includes a computing device coupled to the measurement machine. The computing device can be configured to access a model correlating radial run out of the tire with radial force variation of the tire and to determine an estimated radial uniformity parameter for at least one discrete measurement point for the tire using the model, the model correlating an estimated radial uniformity parameter for a discrete measurement point as a weighted sum of the measured radial uniformity parameter at the discrete measurement point and one or more selected measurement points proximate the discrete measurement point. The estimated uniformity parameter for the at least one discrete measurement point is determined based at least in part on the measured radial uniformity parameter for one or more measurement points proximate to the discrete measurement point on the tire.

Yet another exemplary aspect of the present disclosure is directed to a method for generating a model correlating a measured radial uniformity parameter of a tire with an estimated radial uniformity parameter of the tire. The method includes obtaining measured radial run out data for one or more test tires in a set of test tires and obtaining measured radial force variation data for the one or more test tires in the set of test tires.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

## BRIEF DESCRIPTION OF THE DRAWINGS

A full and enabling disclosure of the present invention, including the best mode thereof, directed to one of ordinary skill in the art, is set forth in the specification, which makes reference to the appended figures, in which:

FIGS. 1 and 2 provide a simplified graphical representation of the transformation of radial run out into radial force variation through action of the contact patch of a tire;

FIG. 3 depicts a flow diagram of an exemplary method for generating a model correlating radial run out and radial force variation of a tire according to an exemplary embodiment of the present disclosure;

FIG. 4 depicts a representation of a plurality of measurement points proximate to a discrete measurement point along a center track of a tire;

FIG. 5 depicts a representation of a plurality of measurement points proximate to a discrete measurement point along a plurality of tracks of a tire;

FIG. 6 depicts a flow diagram of an exemplary method for improving the uniformity of a tire based on convolution-based estimated radial force variation of a tire determined using measured radial run out according to an exemplary embodiment of the present disclosure;

FIG. 7 depicts a flow diagram of an exemplary method for improving the uniformity of a tire based on deconvolution-based estimated radial run out of a tire determined using measured radial force variation according to an exemplary embodiment of the present disclosure; and

FIG. 8 depicts a block diagram of an exemplary system according to an exemplary embodiment of the present disclosure.

## DETAILED DESCRIPTION

It is to be understood by one of ordinary skill in the art that the present discussion is a description of exemplary embodiments only, and is not intended as limiting the broader aspects of the present invention. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims and their equivalents.

Generally, the present disclosure is directed to systems and methods for improving tire uniformity using estimates of a uniformity parameter of a tire. In particular, a first type of radial uniformity parameter of a tire can be estimated from a measured second type of radial uniformity parameter of the tire. The second type of radial uniformity parameter can be a different type of radial uniformity parameter than the first type of radial uniformity parameter. In this way, an estimated radial uniformity parameter can be obtained, for instance, in circumstances when a particular uniformity parameter has not been measured or is otherwise unavailable.

As used herein, a radial uniformity parameter of a tire is a uniformity parameter associated with the radial direction of the tire, such as a radial run out parameter or a radial force variation parameter for the tire. Radial run out is a uniformity parameter directed to the physical out of roundness or geometrical non-uniformity in the radial direction of a tire. Radial force variation (RFV) is a uniformity parameter directed to variations in force reacting in the radial direction on a surface in contact with the tire. The present disclosure will be discussed with reference to low speed uniformity parameters (e.g. radial run out and radial force variation at rotational speeds of less than 600 rotations per minute) for purposes of illustration and discussion. Those of ordinary skill in the art, using the disclosures provided herein, will understand that aspects of the present disclosure can be similarly applicable to other uniformity parameters.

The radial run out of a tire can be transformed through action of the contact patch into radial force variation. Based on this principle, aspects of the present disclosure are directed to translating between radial run out of a tire and radial force variation of a tire. For instance, convolution can be used to estimate radial force variation from one or more uniformity parameter measurements, including radial run out parameter measurements. Deconvolution can be used to estimate radial run out from one or more uniformity parameter measurements, including radial force variation parameter measurements.

According to the invention, the estimated radial uniformity parameter is estimated from the measured radial uniformity parameter using one or more models. The one or more models represent an estimated radial uniformity parameter at a discrete measurement point as a weighted sum of the measured radial uniformity parameter at the discrete measurement point and one or more selected measurement points proximate the discrete measurement point. The selected measurement points proximate to the discrete measurement point can be selected based on the contact patch length of the tire to provide an approximation of the transformation of radial run out to radial force variation through action of the contact patch. The one or more models can be generated by obtaining measured radial run out data and measured radial force variation data for a set of one or more test tires and estimating coefficients for the weighted sum using a regression analysis (e.g. multiple linear regression, Bayesian regression, etc.) or a programming analysis (e.g. a linear programming analysis) based on the measured data.

The estimated radial uniformity parameter can be used for a variety of purposes to improve tire uniformity. For instance, an estimated radial force variation parameter can be used to replace radial force variation measurements used for tire grading/sorting. An estimated radial force variation parameter can also be used, for instance, to replace radial force variation measurements used in dynamic tire uniformity compensation processes, such as green tire correction processes, and can also be used to supplement measured radial force variation used in signature analysis studies. An estimated radial run out parameter can be used, for instance, to track joint formation, and/or to replace or supplement radial run out measurements typically used in process harmonic detection.

An estimated radial force variation parameter can also be used to assess the stiffness of a tire. The radial force variation of a tire can be attributable not only to radial run out through action of the contact patch, but can also be attributable to variations in stiffness of the tire. Any differences in a measured radial force variation and an estimated radial force variation determined according to aspects of the present disclosure can provide an indication of the portion of radial force variation attributable to stiffness. In this manner, an estimated radial force variation for a tire can be compared to a measured radial force variation for the tire to assess the stiffness of the tire.

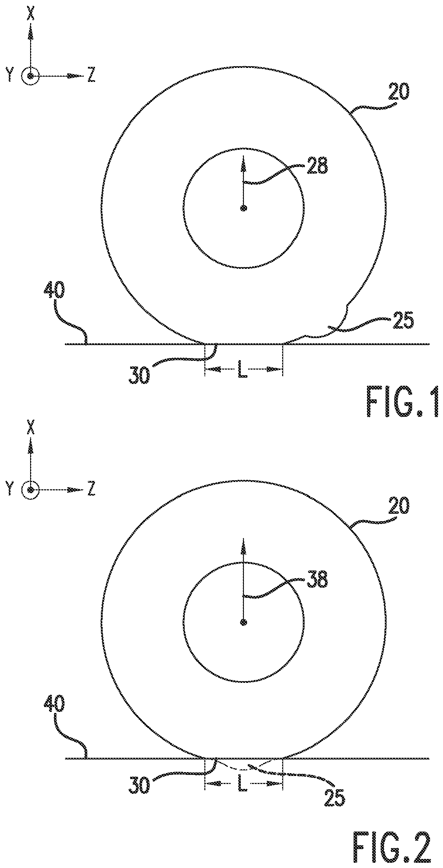

FIGS. 1 and 2 provide a simplified representation of a tire to explain the transformation of radial run out through action of the contact patch to radial force variation. In particular, FIG. 1, illustrates an exemplary tire 20 having radial run out at point 25. The tire 20 rolls on a surface 40. The contact patch 30 is the portion of the tire 20 in contact with the surface 40. The contact patch 30 has a length L. The length L of the contact patch 30 can be dependent on factors such as section width, aspect ratio, seat size, inflation pressure, and load of the tire 20. Radial force 28 acts on the tire 20 along the radial direction (i.e. along the x-axis) in response to the tire 20 rolling on the surface 40. In FIG. 1, the radial run out at point 25 is outside the contact patch 30. As such, the radial run out at point 25 does not contribute to the radial force 28 on the tire 20. The radial force 28 on the tire 20 can result from compression of the tire 20 at the contact patch 30 and factors such as stiffness of the tire 20.

In FIG. 2, the tire 20 has rolled such that radial run out at point 25 is passing through the contact patch 30 of the tire 20. When radial run out at point 25 is passing through the contact patch 30, the radial run out will be compressed (in addition to the nominal deformation due to loading) and radial force 38 will be created. The radial force 38 can result at least in part from compression of the radial run out at point 25 as it passes through the contact patch 30. The radial force 38 for the tire 20 as the radial run out at point 25 passes through the contact patch 30 can be greater than the radial force 28 for the tire 20 when the radial run out 25 is not passing through the contact patch 30. As a result, radial run out contributes to radial force variation of the tire through action of the contact patch.

According to aspects of the present disclosure, one or more models can be generated correlating radial run out and radial force variation of the tire based on the transformation of radial run out to radial force variation through action of the contact patch. The one or more models can be used to estimate radial uniformity parameters from measured radial uniformity parameters. In particular, an estimated radial uniformity parameter at a discrete measurement point can be determined based on a weighted sum of measured radial uniformity parameters at selected measurement points proximate the discrete measurement point, such as measurement points that fall within the contact patch length of the tire relative to the discrete measurement point.

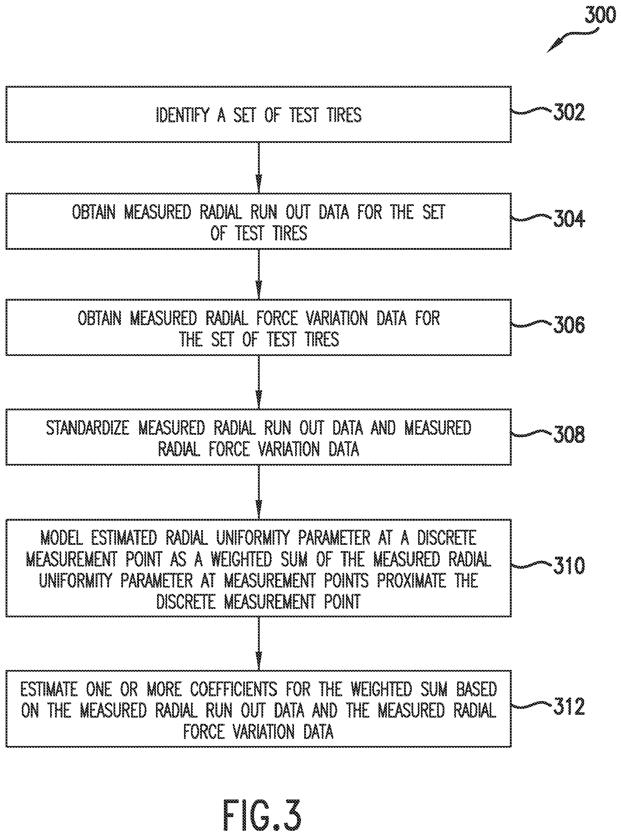

FIG. 3 depicts a flow diagram of an exemplary method (300) for generating a model correlating a measured radial uniformity parameter of a tire with an estimated radial uniformity parameter of the tire. The method (300) depicts steps performed in a particular order for purposes of illustration and discussion. One of ordinary skill in the art, using the disclosures provided herein, will understand that the steps of any of the methods disclosed herein can be adapted, omitted, rearranged, and/or modified in various ways.

At (302), the method includes identifying a set of test tires. The set of test tires can include a plurality of tires of the same or similar tire construction. The set of test tires can include any number of tires suitable for generating a model correlating a measured radial uniformity parameter of a tire with an estimated radial uniformity parameter of the tire according to aspects of the present disclosure. For example, the set of test tires can include a set of 2 to 10 test tires.

At (304), the method includes obtaining measured radial run out data for one or more test tires in the set of test tires. As used herein, obtaining data can include measuring the data, for instance, using a uniformity measurement machine or other suitable device and/or can include accessing previously measured or acquired data stored, for instance, in a memory of a computing device. The radial run out data can include a radial run out waveform measured for each test tire in the set of test tires. The radial run out waveform can provide a measured radial run out parameter (e.g. measured radial run out) of the test tire for a plurality of measurement points at spaced angular locations about the circumference of the test tire (e.g. 128, 256, 512 or other suitable number measurement points).

At (306), the method includes obtaining measured radial force variation data for one or more test tires in the set of test tires. Similar to the radial run out data, the radial force variation data can include a radial force variation waveform measured for each test tire in the set of test tires. The radial force variation waveform can provide a measured radial force variation parameter (e.g. measured radial force) of the test tire for a plurality of measurement points at spaced angular locations about the circumference of the test tire. The radial force variation data can be obtained for rotation of the tire in both the clockwise and counterclockwise direction. The radial force variation data can also include various derived measures, such as an average radial force variation determined based on measured radial force variation for both clockwise and counterclockwise rotation of the tire.

At (308), the radial run out data and the radial force variation data for the set of test tires is standardized for purposes of determining the model. Standardization can be performed by subtracting a mean from each data point in the radial run out data and the radial force variation and dividing each data point by the standard deviation of the data to center data at zero and account for any measurement offsets.

At (310), the model is generated by modeling the estimated radial uniformity parameter as a weighted sum of a measured radial uniformity parameter at the discrete measurement point and one or more measurement points proximate to the discrete measurement point. The one or more measurement points proximate the discrete measurement point used in the model can be selected based on the contact patch length associated with the test tires so that the model provides a good approximation of the transformation of radial run out to radial force variation through action of the contact patch.

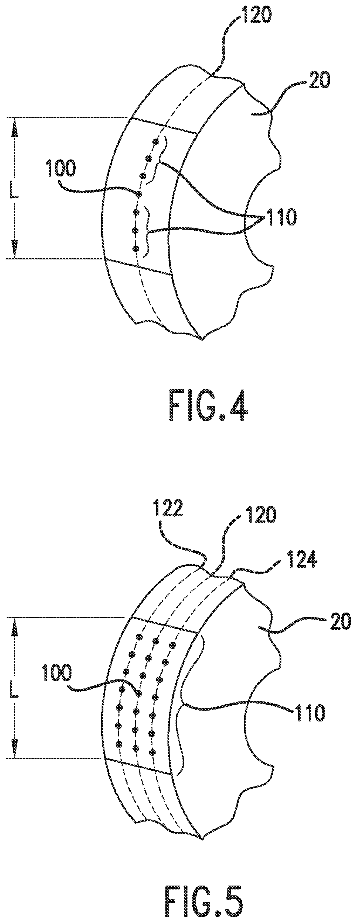

One exemplary model that can be generated according to exemplary aspects of the present disclosure is a convolution model correlating an estimated radial force variation parameter at a discrete measurement point with the radial run out parameters at a plurality of measurement points along a center track of the tire. This particular convolution model can be more readily understood with reference to FIG. 4 of the present disclosure.

FIG. 4 depicts a portion of tire 20. The radial run out data can provide a plurality of radial run out measurements for measurement points along a center track 120 of the tire 20. The convolution model can represent an estimated radial force variation parameter at a discrete measurement point 100 as a weighted sum of the measured radial run out parameter at the discrete measurement point 100 in addition to the measured radial run out parameter at one or more measurement points 110 proximate to the discrete measurement point 100.

As shown in FIG. 4, the measurement points 110 are selected to provide an approximation of the measurement points within the contact patch length L of the tire relative to the discrete measurement point 100. One or more of the measurement points 110 can be used in the convolution model. For instance, in one implementation, all measurement points 110 can be used in the convolution model. In another implementation, selected of the measurement points 110, such as the outer measurement points (i.e. the measurement points 110 the furthest distance away from the discrete measurement point 100) can be used in the convolution model.

The convolution model according to this exemplary embodiment can be represented as follows:

$$vr_i = \sum_{k=-j}^{k=j} \alpha_{i+k} * frc_{i+k} \qquad (1)$$

This convolution model represents radial force variation rv at a discrete measurement point $i$ as a weighted sum of measured radial run out $frc$ at each measurement point $i+k$ proximate to and including the discrete measurement point. $a_{i+k}$ represents coefficients associated with measurement points $i+k$ used in the weighted sum. $k$ can range from $-j$ to $j$ depending on the particular tire construction. The size of $j$ can be based on the contact patch length of the tire.

In one example, *j* is equal to 3 such that measured radial run out associated with 7 measurement points is used to estimate radial force variation at the discrete measurement point. It has been discovered that 7 measurement points can provide a good approximation of the contact patch length for certain tires when 128 equally spaced measurement points are provided about the tire. More or fewer measurement points can be used without deviating from the scope of the present disclosure.

Another exemplary model that can be generated according to exemplary aspects of the present disclosure is a convolution model correlating an estimated radial force variation at a discrete measurement point with radial run out at a plurality of measurement points along a plurality of tracks of the tire. The use of a plurality of tracks of radial run out measurements can increase the accuracy of the convolution model. A convolution model generated based on radial run out data for a plurality of tracks can be more readily understood with reference to FIG. 5 of the present disclosure.

FIG. 5 depicts a portion of tire 20. Radial run out data can provide a plurality of radial run out measurements along a center track 120 of the tire 20. The radial run out data can also provide a plurality of radial run out measurements along additional tracks of the tire 20, such as along tracks 122 and 124 of the tire 20. The convolution model can represent an estimated radial force variation parameter at a discrete measurement point 100 as a weighted sum of the measured radial run out at the discrete measurement point 100 in addition to one or more measurement points 110 along the plurality of tracks 120, 122, and 124 proximate to the discrete measurement point 100.

As shown in FIG. 5, the measurement points 110 proximate to the discrete measurement point are selected to provide an approximation of the measurement points within the contact patch length L of the tire relative to the discrete measurement point 100. One or more of the measurement points 110 can be used in the convolution model. For instance, in one implementation, all measurement points 110 can be used in the convolution model. In another implementation, selected of the measurement points 110 can be used in the convolution model.

A convolution model involving a plurality of radial run out tracks can be represented as follows:

$$vr_i = \sum_{l=1}^{l=n} \sum_{k=-j}^{k=j} \alpha_{li+k} * frc_{li+k} \qquad (2)$$

This convolution model represents radial force variation rv at a discrete measurement point *i* as a weighted sum of measured radial run out *frc* at each measurement point *i+k* for *n* tracks proximate to and including the discrete measurement point. $_{\alpha li+k}$ represents coefficients associated with measurement points *i+k* for each of the *n* tracks used in the weighted sum. *k* can range from *-j* to *j* depending on the particular tire construction.

A convolution model for the particular embodiment with three radial run out tracks is provided below:

$$vr_i = \sum_{k=-j}^{k=j} \alpha_{i+k} * frc_{i+k} + \sum_{k=-j}^{k=j} \lambda_{i+k} * frt_{i+k} + \sum_{k=-j}^{k=j} \gamma_{i+k} * frb_{i+k} \qquad (3)$$

This exemplary model represents radial force variation rv at a discrete measurement point *i* as a weighted sum of measured radial run out *frc* at each measurement point *i+k* for a center track, measured radial run out *frt* at each measurement point *i+k,* for a top track, and measured radial run out *frb* at each measurement point *i+k* for a bottom track. $\alpha_{i+k}$ represents coefficients associated with measurement points *i+k* for the center track. $\lambda_{i+k}$ represents coefficients associated with measurement points *i+k* for the top track. $\gamma_{i+k}$ represents coefficients associated with measurement points *i+k* for the bottom track. *k* can range from *-j* to *j* depending on the particular tire construction. The size of *j* can be based on the contact patch length of the tire.

Yet another exemplary model can be a deconvolution model correlating an estimated radial run out parameter at a discrete measurement point along a center track with measured radial force variation. The deconvolution model can also be understood with reference to FIG. 4 of the present disclosure. In particular, the radial force variation data can provide a plurality of radial force measurements for the tire 20. The deconvolution model can estimate radial run out at a discrete measurement point 100 along a center track 120 of the tire 20 as a weighted sum of the measured radial force variation at the discrete measurement point 100 in addition to one or more measurement points 110 proximate to the discrete measurement point 100.

The deconvolution model can be represented as follows:

$$frc_i = \sum_{k=-j}^{k=j} \delta_{i+k} * vr_{i+k} \qquad (4)$$

This deconvolution model represents radial run out *frc* at a discrete measurement point *i* along a center track of a tire as a weighted sum of measured radial force variation vr at each measurement point *i+k* proximate to and including the discrete measurement point. $\delta_{i+k}$ represents coefficients associated with measurement points *i+k* used in the weighted sum. *k* can range from *-j* to *j* depending on the particular tire construction.

Referring back to FIG. 3 at (312) after the estimated radial uniformity parameter has been modeled as discussed above, the coefficients associated with the one or more models need to be estimated using the measured radial run out data and the measured radial force variation data. In particular, the measured radial run out data and the measured radial force variation data can be substituted into the model. The coefficients provided by the model can then be estimated based on the data. Constant coefficients can be estimated based on measured data for all sectors (each discrete measurement point) of the test tires in the set of test tires. The coefficients can be estimated using any suitable technique, such as a regression technique or a programming technique.

In one implementation, the coefficients can be estimated using multiple linear regression. Multiple linear regression can estimate a unique set of coefficients that minimizes the sum of the squared errors between the estimated radial uniformity parameter and the measured radial uniformity parameter data. In the multiple linear regression approach, the estimated coefficients are essentially unconstrained and estimates can sometimes not meet physical expectations. The solution can come directly from a matrix equation.

In another implementation, the coefficients can be estimated using Bayesian regression. Bayesian regression also minimizes the sum of the squared errors but it does so by maximizing the posterior probability that the model is correct given the observed data. This requires that a prior probability that the model is correct be provided. This addition allows for the conditioning of the final estimated coefficients to be more physically realistic. Depending on the type of prior probability that is used, the solution can either come directly from a matrix equation or from an iterative search. The prior probability can be used to condition the results but it is not an absolute constraint on the final estimates of the coefficients. For example a suitable prior probability might condition the estimates to be lower at the edges of the contact patch and higher in the center.

In yet another implementation, a linear programming approach can be used to implement an L1 optimization that minimizes the sum of the absolute errors. This approach can provide for constraining the estimates to match physical expectations in an explicit manner. For instance, the coefficients can be expected to be smaller for measurement points proximate the edges of the contact patch than at the center. The coefficient pattern can also be expected to be reasonably symmetric around the center of the contact patch. The final solution under this approach can be the optimal set of coefficients that both meet the constraints and minimize the sum of the absolute errors. This approach can be particularly suitable for estimating coefficients for convolution/deconvolution models because of the ability to force the estimates of the coefficients to meet physical expectations.

Once the one or more models for translating between radial run out and radial force variation have been generated according to aspects of the present disclosure, the models can be accessed and used to determine an estimated radial uniformity parameter for the tire. For instance, a convolution model can be used to estimate radial force variation from radial run out measurements. A deconvolution model can be used to estimate radial run out from radial force variation measurements. The estimated radial uniformity parameter(s) can then be used in a variety of manners to improve the uniformity of a tire.

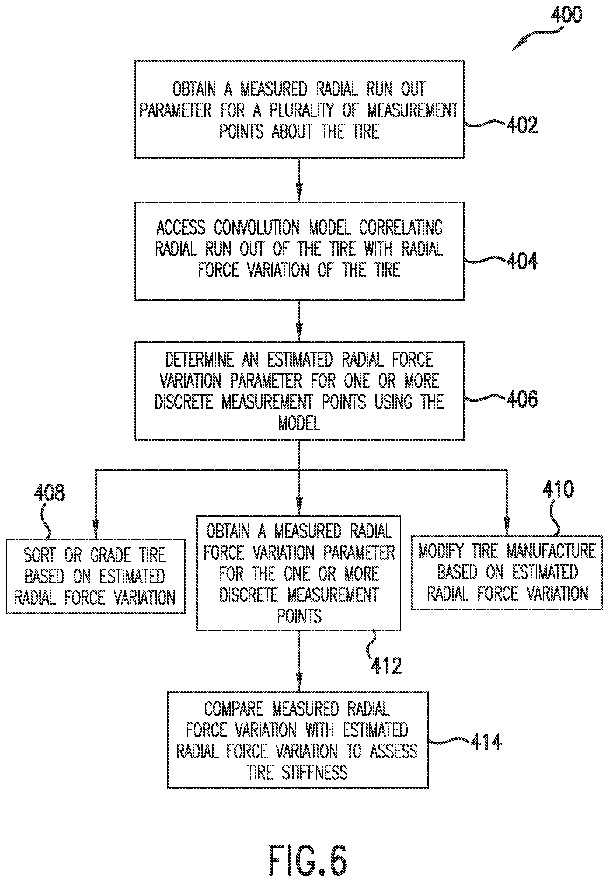

FIG. 6 depicts a flow diagram of an exemplary method (400) of improving the uniformity of a tire using convolution-based estimated radial force variation of a tire determined using measured radial run out according to an exemplary embodiment of the present disclosure. At (402), the method includes obtaining a measured radial run out parameter for a plurality of measurement points about a tire. As used herein, obtaining a uniformity parameter can include measuring the uniformity parameter using a uniformity measurement machine or other suitable measurement machine and/or can include accessing previously measured uniformity parameters stored, for instance, in a memory. The measured radial run out parameter can include or be a part of a measured radial run out waveform for a plurality of points (e.g. 128 points) about one or more tracks on the surface of the tire.

At (404), the method includes accessing a model correlating radial force variation with the radial run out of the tire. Accessing the model can include accessing a model stored in a memory of a computing device. The model can be a convolution model correlating radial force variation of a tire with measured radial run out. For instance, the model can be a convolution model correlating estimated radial force variation with radial run out measured for a center track of the tire or with radial run out measured for a plurality of tracks about the tire.

At (406), the estimated radial force variation parameter is determined for one or more discrete measurement points on the tire using the model. In particular, the measured radial run out for the discrete measurement point and/or one or more measurement points proximate the discrete measurement point are substituted into convolution model. The estimated radial force variation parameter at the discrete measurement is then calculated from the measured radial run out using the convolution model. This process can be repeated for each discrete measurement point to generate an estimated radial force variation waveform for the tire.

For instance, referring to the example tire 20 of FIG. 4, measured radial run out parameters for the discrete measurement 100 and the measurement points 110 proximate the discrete measurement point along the center track 120 of the tire 20 are substituted into the convolution model represented by equation (1) above. The estimated radial force variation parameter for the discrete measurement point 100 is then calculated using the convolution model represented by equation (1).

As another example and referring to the example tire 20 of FIG. 5, measured radial run out parameters for the discrete measurement point 100 and the measurement points 110 along the plurality of tracks 120, 122, and 125 can be substituted into the convolution model represented by equation (3) above. The estimated radial force variation parameter for the discrete measurement point 100 is then calculated using the convolution model represented by equation (3). As demonstrated by the example below, the estimated radial force variation parameter calculated using radial run out measured for a plurality of tracks (e.g. tracks 120, 122, and 125) can more closely approximate the actual radial force variation at the discrete measurement point.

Once the estimated radial force variation parameter has been determined using the convolution model, the estimated radial force variation parameter can be used to improve uniformity of the tire. For instance, at (408), the method can include sorting or grading the tire based on the estimated radial force variation parameter. At (410), the method can include modifying tire manufacture based on the estimated radial force variation parameter. For example, correction techniques can be performed (e.g. addition or removal of tire material) on the tire to reduce the estimated radial force variation. As another example, the estimated radial force variation can be used as part of a uniformity compensation method such as signature analysis or as part of a green tire correction process.

The estimated radial force variation parameter can also be used to assess the stiffness of the tire. The stiffness of the tire would be the radial force variation that is not dependent on radial run out. To assess tire stiffness, the method can include obtaining a measured radial force variation parameter for the one or more discrete measurement points (412). The estimated radial force variation parameter is then compared with the measured radial force variation at the one or more discrete measurement points to assess tire stiffness (414). For instance, any differences between the measured and estimated radial force variation can provide an indication of the amount of radial force at the one or more discrete measurement points is attributable to tire stiffness.

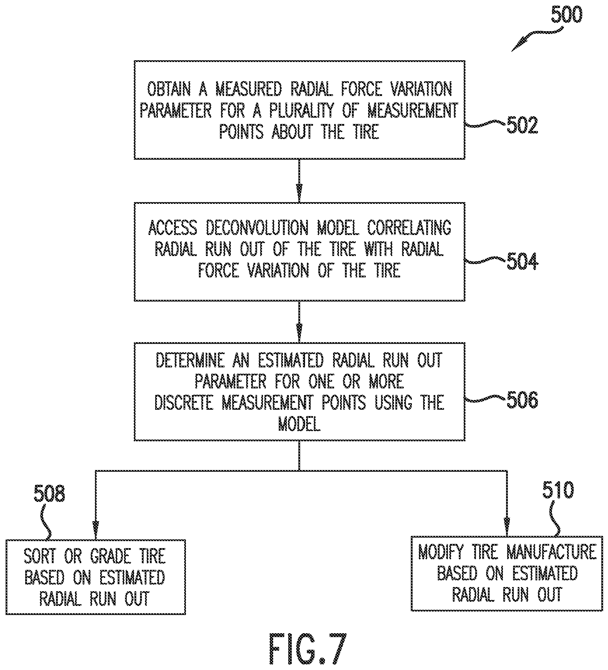

FIG. 7 depicts a flow diagram of an exemplary method (500) for improving tire uniformity using a deconvolution-based estimated radial run out parameter of a tire determined using measured radial force variation according to an exemplary embodiment of the present disclosure. At (502), the method includes obtaining a measured radial force variation parameter for a plurality of measurement points about a tire. At (504), the method includes accessing a model correlating radial force variation with the radial run out of the tire. The model can be a deconvolution model correlating radial run out of a tire with measured radial force variation.

At (506), the estimated radial run out parameter is determined for one or more discrete measurement points on the tire using the model. In particular, the measured radial force variation for the discrete measurement point and/or one or more measurement points proximate the discrete measurement point are substituted into deconvolution model. The estimated radial run out parameter at the discrete measurement is then calculated from the measured radial force variation using the deconvolution model.

For instance, referring the example tire 20 of FIG. 4, measured radial force variation parameters for the discrete measurement 100 and the measurement points 110 proximate the discrete measurement point are substituted into the deconvolution model represented by equation (4) above. The estimated radial run out parameter for the discrete measurement point 100 is then calculated using the deconvolution model represented by equation (4). This process can be repeated for a plurality of discrete measurement point about the circumference of the tire to generate an estimated radial run out waveform for the tire.

Once the estimated radial run out parameter has been determined using the deconvolution model, the estimated radial run out parameter can be used to assess and/or improve uniformity of the tire. For instance, at (508) of FIG. 7, the method can include sorting or grading the tire based on the estimated radial run out parameter. At (510), the method can include modifying tire manufacture based on the estimated radial run out parameter. For example, correction techniques can be performed (e.g. addition or removal of tire material) on the tire to reduce the estimated radial run out. As another example, the estimated radial run out can be used as part of a signature analysis, joint tracking, and/or process harmonic detection.

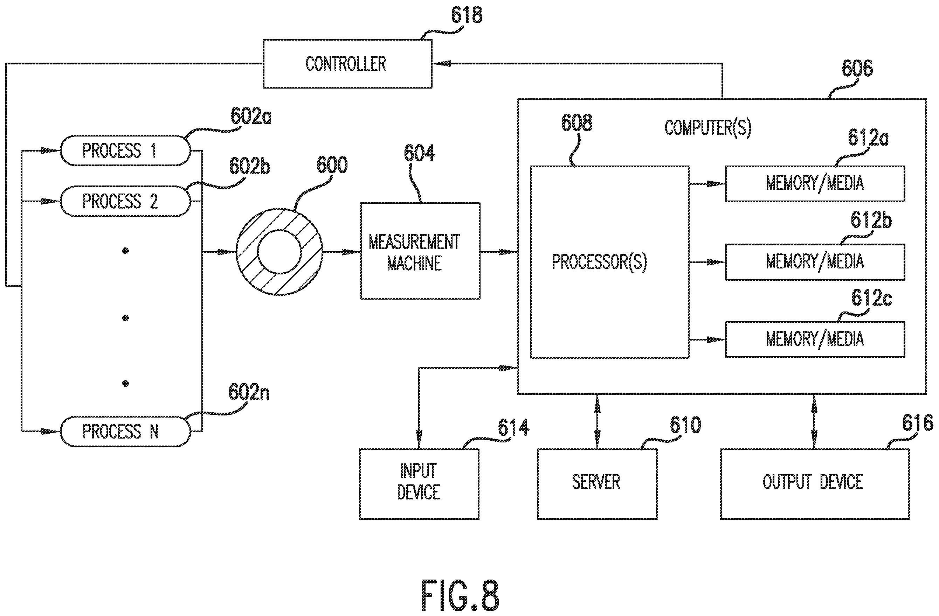

Referring now to FIG. 8, a schematic overview of exemplary system components for implementing the above-described methods are illustrated. An exemplary tire 600 is constructed in accordance with a plurality of respective manufacturing processes. Such tire building processes may, for example, include applying various layers of rubber compound and/or other suitable materials to form the tire carcass, providing a tire belt portion and a tread portion to form the tire summit block, positioning a green tire in a curing mold, and curing the finished green tire, etc. Such respective process elements are represented as 602a, 602b,..., 602n in FIG. 8 and combine to form exemplary tire 600. It should be appreciated that a batch of multiple tires can be constructed from one iteration of the various processes 602a through 602n.

Referring still to FIG. 8, a measurement machine 604 is provided to obtain the various uniformity measurements. In general, such a measurement machine can include such features as a mounting fixture on which a tire is mounted and rotated centrifugally at one or more speeds. In one example, laser sensors are employed to operate by contact, non-contact or near contact positioning relative to tire 600 in order to determine the relative position of the tire surface at multiple data points (e.g., 128 points) as it rotates about a center line. The measurement machine can also include a road wheel used to load the tire to obtain force measurements as the tire is rotated in the measurement machine 604.

The measurements obtained by measurement machine 604 can be relayed such that they are received at one or more computing devices 606, which may respectively contain one or more processors 608, although only one computer and processor are shown in FIG. 8 for ease and clarity of illustration. Processor(s) 608 may be configured to receive input data from input device 614 or data that is stored in memory 612. Processor(s) 608, can then analyze such measurements in accordance with the disclosed methods, and provide useable output such as data to a user via output device 616 or signals to a process controller 618. Uniformity analysis may alternatively be implemented by one or more servers 610 or across multiple computing and processing devices.

Various memory/media elements 612a, 612b, 612c (collectively, "612") may be provided as a single or multiple portions of one or more varieties of computer-readable media, including, but not limited to, non-transitory computer-readable media, RAM, ROM, hard drives, flash drives, optical media, magnetic media or other memory devices. The computing/processing devices of FIG. 8 may be adapted to function as a special-purpose machine providing desired functionality by accessing software instructions rendered in a computer-readable form stored in one or more of the memory/media elements. When software is used, any suitable programming, scripting, or other type of language or combinations of languages may be used to implement the teachings contained herein.

Example

Radial run out data for a center track as well as radial run out data for three tracks were obtained for a set of test four tires. Radial force variation data were obtained for the set of test tires. A first convolution model was generating in accordance with aspects of the present disclosure using the radial force variation data and the radial run out data for the center track. A second convolution model was generated in accordance with aspects of the present disclosure using the radial force variation data and the radial run out data for three tracks. Coefficients for the first and second convolution models were estimated using a regression analysis. Table 1 below compares the $R^2$ values (coefficient of determination) and the RSME values (Root Mean Squared Error) of the first convolution model and the second convolution model.

Table 1

| Tire | $R^2$ Center Track | RSME Center Track | $R^2$ Three Track | RSME Three Track | % $R^2$ Gain for Three Track | % RSME Gain for Three Track |
|---|---|---|---|---|---|---|
| Tire 1 | 53.84% | 1.1425 | 65.89% | .99475 | 22.4% | 12.9% |
| Tire 2 | 48.30% | 1.0718 | 86.38% | .55477 | 78.8% | 48.2% |
| Tire 3 | 63.33% | .9006 | 75.47% | .73600 | 19.2% | 18.3% |
| Tire 4 | 52.07% | 1.2291 | 65.88% | 1.0458 | 26.5% | 14.9% |
| Average | 54.38% | 1.0860 | 73.41% | .83283 | 33.8% | 24.2% |

As demonstrated, the convolution model generated based on the center track radial run out data provides a good model correlating radial force variation and radial run out. However, use of three track radial run out data can improve the accuracy of the model significantly.

While the present subject matter has been described in detail with respect to specific exemplary embodiments and methods thereof, it will be appreciated that those skilled in the art, upon attaining an understanding of the foregoing may readily produce alterations to, variations of, and equivalents to such embodiments. Accordingly, the scope of the present disclosure is by way of example rather than by way of limitation, and the subject disclosure does not preclude inclusion of such modifications, variations and/or additions to the present subject matter as would be readily apparent to one of ordinary skill in the art using the teachings disclosed herein.

**Claims**

1.  A method (300, 400,500) for estimating the uniformity of a tire (20), comprising:

    obtaining a measured radial uniformity parameter for a plurality of measurement points (110) about the tire (20);
    accessing a model correlating radial run out of the tire (20) with radial force variation of the tire (20), the model correlating an estimated radial uniformity parameter at a discrete measurement point (100) as a weighted sum of the measured radial uniformity parameter at the discrete measurement point (100) and one or more selected measurement points (110) proximate the discrete measurement point (100); and
    determining, with a computing device (606), the estimated radial uniformity parameter for at least one discrete measurement point (100) for the tire (20) using the model;
    wherein the estimated radial uniformity parameter for the at least one discrete measurement point (100) is determined based at least in part on the measured radial uniformity parameter for one or more measurement points (110) proximate to the discrete measurement point (100) on the tire (20).

2.  The method (300, 400, 500) of claim 1, wherein the one or more measurement points (110) proximate to the discrete measurement point (100) are selected based on a contact patch length (L) of the tire (20).

3.  The method (300, 400, 500) of claim 1, wherein the measured radial uniformity parameter is a measured radial run out parameter and the estimated radial uniformity parameter is an estimated radial force variation parameter.

4.  The method (300, 400, 500) of claim 3, wherein the measured radial run out parameter is measured for a plurality of measurement points (110) about a center track (120) for the tire (20).

5.  The method (300, 400, 500) of claim 3, wherein the measured radial run out parameter is measured for a plurality of measurement points about a plurality of tracks (120, 122, 125) for the tire (20).

6.  The method (300, 400, 500) of claim 1, wherein the measured radial uniformity parameter is a measured radial force variation parameter and the estimated radial uniformity parameter is an estimated radial run out parameter.

7.  The method (300, 400, 500) of claim 6, wherein the estimated radial run out parameter is determined for a discrete measurement point (100) located on a center track (120) for the tire (20).

8.  The method (300, 400, 500) of claim 1, wherein the method (300, 400, 500) comprises:

    obtaining a measured estimated radial uniformity parameter for the discrete measurement point (100); and
    comparing the measured estimated radial uniformity parameter for the discrete measurement point (100) with the estimated radial uniformity parameter determined using the model to assess a stiffness of the tire (20).

9.  The method (300, 400, 500) of claim 1, wherein the method (300, 400, 500) comprises generating, with the computing device (606), the model correlating radial run out and radial force variation of the tire (20).

10. The method (300, 400, 500) of claim 9, wherein the model comprises a convolution model correlating an estimated radial force variation parameter at a discrete measurement point (100) with a measured radial run out parameter for one or more measurement points proximate to the discrete measurement point (100).

11. The method (300, 400, 500) of claim 10, wherein generating the model (300, 400, 500) comprises:

    obtaining measured radial run out data for one or more tires (20) in a set of test tires;
    obtaining measured radial force variation data for the one or more tires (20) in the set of test tires;
    modeling the estimated radial force variation parameter at the discrete measurement point (100) as a weighted sum of the measured radial run out parameter at one or more measurement points (110) proximate to the discrete measurement point (100); and
    estimating, with a computing device (606), one or more coefficients for the weighted sum based on the measured radial run out data and the measured radial force variation data.

12. The method (300, 400, 500) of claim 11, wherein the one or more coefficients are estimated using a regression analysis or a programming analysis.

**13.** The method (300, 400, 500) of claim 9, wherein the model comprises a deconvolution model correlating an estimated radial run out parameter at a discrete measurement point (100) with a measured radial force variation parameter for one or more measurement points (110) proximate to the discrete measurement point (100).

**14.** The method (300, 400, 500) of claim 13, wherein generating the model comprises:

obtaining measured radial run out data for one or more tires (20) in a set of test tires;
obtaining measured radial force variation data for the one or more tires (20) in the set of test tires;
modeling the estimated radial run out parameter at the discrete measurement point (100) as a weighted sum of the measured radial force variation parameter at one or more measurement points (110) proximate to the discrete measurement point (100); and
estimating one or more coefficients for the weighted sum based on the measured radial run out data and the measured radial force variation data.

**15.** A system for estimating a uniformity parameter of a tire (20), the system comprising:

a measurement machine (604) configured to acquire a measured radial uniformity parameter for a plurality of measurement points (110) about a tire (20);
a computing device (606) coupled to said measurement machine (604), the computing device (606) configured to access a model correlating radial run out of the tire (20) with radial force variation of the tire (20) and to determine an estimated radial uniformity parameter for at least one discrete measurement point (100) for the tire (20) using the model, the model correlating an estimated radial uniformity parameter at a discrete measurement point (100) as a weighted sum of the measured radial uniformity parameter at the discrete measurement point (100) and one or more selected measurement points (110) proximate the discrete measurement point (100);
wherein the estimated radial uniformity parameter for the at least one discrete measurement point (100) is determined based at least in part on the measured radial uniformity parameter for one or more measurement points (110) proximate to the discrete measurement point (100) on the tire (20).

**Patentansprüche**

**1.** Verfahren (300, 400, 500) zum Schätzen der Gleichförmigkeit eines Reifens (20), mit den folgenden Schritten:

Erhalten eines Parameters der gemessenen radialen Gleichförmigkeit für eine Vielzahl von Messpunkten (110) um den Reifen (20);
Zugreifen auf ein Modell, das den Rundlauffehler des Reifens (20) mit der Radialkraftschwankung des Reifens (20) korreliert, wobei das Modell einen Parameter der geschätzten radialen Gleichförmigkeit an einem diskreten Messpunkt (100) als gewichtete Summe des Parameters der gemessenen radialen Gleichförmigkeit an dem diskreten Messpunkt (100) und an einem oder mehreren ausgewählten Messpunkten (110) in der Nähe des diskreten Messpunkts (100) korreliert; und
Ermitteln, mit Hilfe einer Rechenvorrichtung (606), des Parameters der geschätzten radialen Gleichförmigkeit für mindestens einen diskreten Messpunkt (100) für den Reifen (20) unter Verwendung des Modells;
wobei der Parameter der geschätzten radialen Gleichförmigkeit für den mindestens einen diskreten Messpunkt (100) wenigstens teilweise anhand des Parameters der gemessenen radialen Gleichförmigkeit für einen oder mehrere Messpunkte (110) in der Nähe des diskreten Messpunkts (100) auf dem Reifen (20) ermittelt wird.

**2.** Verfahren (300, 400, 500) nach Anspruch 1, wobei der eine oder mehrere Messpunkte (110) in der Nähe des diskreten Messpunkts (100) anhand einer Aufstandsflächenlänge (L) des Reifens (20) ausgewählt werden.

**3.** Verfahren (300, 400, 500) nach Anspruch 1, wobei der Parameter der gemessenen radialen Gleichförmigkeit ein Parameter des gemessenen Rundlauffehlers ist und der Parameter der geschätzten radialen Gleichförmigkeit ein Parameter der geschätzten Radialkraftschwankung ist.

**4.** Verfahren (300, 400, 500) nach Anspruch 3, wobei der Parameter des gemessenen Rundlauffehlers für eine Vielzahl von Messpunkten (110) um eine mittlere Spur (120) für den Reifen (20) gemessen wird.

**5.** Verfahren (300, 400, 500) nach Anspruch 3, wobei der Parameter des gemessenen Rundlauffehlers für eine Vielzahl von Messpunkten um eine Vielzahl von Spuren (120, 122, 125) für den Reifen (20) gemessen wird.

**6.** Verfahren (300, 400, 500) nach Anspruch 1, wobei der Parameter der gemessenen radialen Gleichförmigkeit ein Parameter der gemessenen Radialkraftschwankung ist und der Parameter der geschätzten radialen Gleichförmigkeit ein Parameter des geschätzten Rundlauffehlers ist.

**7.** Verfahren (300, 400, 500) nach Anspruch 6, wobei der Parameter des geschätzten Rundlauffehlers für einen auf einer mittleren Spur (120) befindlichen diskreten Messpunkt (100) für den Reifen (20) ermittelt wird.

**8.** Verfahren (300, 400, 500) nach Anspruch 1, wobei das Verfahren (300, 400, 500) folgende Schritte umfasst:

Erhalten eines gemessenen Parameters der geschätzten radialen Gleichförmigkeit für den diskreten Messpunkt (100); und
Vergleichen des gemessenen Parameters der geschätzten radialen Gleichförmigkeit für den diskreten Messpunkt (100) mit dem Parameter der geschätzten radialen Gleichförmigkeit unter Verwendung des Modells zur Beurteilung einer Steifigkeit des Reifens (20).

**9.** Verfahren (300, 400, 500) nach Anspruch 1, wobei das Verfahren (300, 400, 500) das Generieren, mit Hilfe der Rechenvorrichtung (606), des den Rundlauffehler und die Radialkraftschwankung des Reifens (20) korrelierenden Modells umfasst.

**10.** Verfahren (300, 400, 500) nach Anspruch 9, wobei das Modell ein Faltungsmodell umfasst, das einen Parameter der geschätzten Radialkraftschwankung an einem diskreten Messpunkt (100) mit einem Parameter des gemessenen Rundlauffehlers für einen oder mehrere Messpunkte in der Nähe des diskreten Messpunkts (100) korreliert.

**11.** Verfahren (300, 400, 500) nach Anspruch 10, wobei das Generieren des Modells (300, 400, 500) Folgendes umfasst:

Erhalten von Daten des gemessenen Rundlauffehlers für einen oder mehrere Reifen (20) in einem Satz von Testreifen;
Erhalten von Daten der gemessenen Radialkraftschwankung für einen oder mehrere Reifen (20) in dem Satz von Testreifen;
Modellieren des Parameters der geschätzten Radialkraftschwankung an dem diskreten Messpunkt (100) als gewichtete Summe des Parameters des gemessenen Rundlauffehlers an einem oder mehreren Messpunkten (110) in der Nähe des diskreten Messpunkts (100); und
Schätzen, mit einer Rechenvorrichtung (606), eines oder mehrerer Koeffizienten für die gewichtete Summe anhand der Daten des gemessenen Rundlauffehlers und der Daten der gemessenen Radialkraftschwankung.

**12.** Verfahren (300, 400, 500) nach Anspruch 11, wobei der eine oder mehrere Koeffizienten unter Verwendung einer Regressionsanalyse oder einer Programmieranalyse geschätzt werden.

**13.** Verfahren (300, 400, 500) nach Anspruch 9, wobei das Modell ein Entfaltungsmodell umfasst, das einen Parameter des geschätzten Rundlauffehlers an einem diskreten Messpunkt (100) mit einem Parameter der gemessenen Radialkraftschwankung für einen oder mehrere Messpunkte (110) in der Nähe des diskreten Messpunkts (100) korreliert.

**14.** Verfahren (300, 400, 500) nach Anspruch 13, wobei das Generieren des Modells folgende Schritte umfasst:

Erhalten von Daten des gemessenen Rundlauffehlers für einen oder mehrere Reifen (20) in einem Satz von Testreifen;
Erhalten von Daten der gemessenen Radialkraftschwankung für den einen oder mehrere Reifen (20) in dem Satz von Testreifen;
Modellieren des Parameters des geschätzten Rundlauffehlers an dem diskreten Messpunkt (100) als gewichtete Summe des Parameters der gemessenen Radialkraftschwankung an einem oder mehreren Messpunkten (110) in der Nähe des diskreten Messpunkts (100); und
Schätzen eines oder mehrerer Koeffizienten für die gewichtete Summe anhand der Daten des gemessenen Rundlauffehlers und der Daten der gemessenen Radialkraftschwankung.

**15.** System zum Schätzen eines Gleichförmigkeitsparameters eines Reifens (20), wobei das System Folgendes umfasst:

eine Messmaschine (604), die dazu ausgebildet ist, einen Parameter der gemessenen radialen Gleichförmigkeit für eine Vielzahl von Messpunkten (110) um einen Reifen (20) zu erfassen;

eine Rechenvorrichtung (606), die mit der Messmaschine (604) gekoppelt ist, wobei die Rechenvorrichtung (606) dazu ausgebildet ist, auf ein Modell zuzugreifen, das den Rundlauffehler des Reifens (20) mit der Radialkraftschwankung des Reifens (20) korreliert, und einen Parameter der geschätzten radialen Gleichförmigkeit für mindestens einen diskreten Messpunkt (100) für den Reifen (20) unter Verwendung des Modells zu ermitteln, wobei das Modell einen Parameter der geschätzten radialen Gleichförmigkeit an einem diskreten Messpunkt (100) als gewichtete Summe des Parameters der gemessenen radialen Gleichförmigkeit an dem diskreten Messpunkt (100) und an einem oder mehreren ausgewählten Messpunkten (110) in der Nähe des diskreten Messpunkts (100) korreliert;

wobei der Parameter der geschätzten radialen Gleichförmigkeit für den mindestens einen diskreten Messpunkt (100) wenigstens teilweise anhand des Parameters der gemessenen radialen Gleichförmigkeit für einen oder mehrere Messpunkte (110) in der Nähe des diskreten Messpunkts (100) auf dem Reifen (20) ermittelt wird.

## Revendications

1. Procédé (300, 400, 500), destiné à estimer l'uniformité d'un pneu (20), comprenant les opérations, consistant à:

   obtenir un paramètre d'uniformité radiale mesuré pour une pluralité de points de mesure (110) concernant le pneu (20);

   accéder à un modèle, corrélant la tolérance d'excentricité radiale du pneu (20) avec une variation de la force radiale du pneu (20), le modèle corrélant un paramètre d'uniformité radiale estimé à un point de mesure discrète (100), au titre d'une somme pondérée du paramètre d'uniformité radiale mesuré au point de mesure discrète (100) et d'un ou plusieurs points de mesure sélectionnés (110), proches du point de mesure discrète (100) ; et

   déterminer, avec un dispositif informatique (606), le paramètre d'uniformité radiale estimé pour au moins un point de mesure discrète (100) pour le pneu (20) qui utilise le modèle;

   dans lequel le paramètre d'uniformité radiale estimé pour le au moins un point de mesure discrète (100) est déterminé en fonction, au moins en partie, du paramètre d'uniformité radiale mesuré pour un ou plusieurs points de mesure (110), proches du point de mesure discrète (100) sur le pneu (20).

2. Procédé (300, 400, 500) selon la revendication 1, dans lequel les un ou plusieurs points de mesure (110), proches du point de mesure discrète (100), sont sélectionnés en fonction d'une longueur (L) d'aire de contact du pneu (20).

3. Procédé (300, 400, 500) selon la revendication 1, dans lequel le paramètre d'uniformité radiale mesuré est un paramètre de tolérance d'excentricité radiale mesuré et le paramètre d'uniformité radiale estimé est un paramètre de variation de force radiale estimé.

4. Procédé (300, 400, 500) selon la revendication 3, dans lequel le paramètre de tolérance d'excentricité radiale mesuré est mesuré pour une pluralité de points de mesure (110) autour d'une voie centrale (120) du pneu (20).

5. Procédé (300, 400, 500) selon la revendication 3, dans lequel le paramètre de tolérance d'excentricité radiale mesuré est mesuré pour une pluralité de points de mesure concernant une pluralité de voies (120, 122, 125) du pneu (20).

6. Procédé (300, 400, 500) selon la revendication 1, dans lequel le paramètre d'uniformité radiale mesuré est un paramètre de variation de force radiale mesuré et le paramètre d'uniformité radiale estimé est un paramètre de tolérance d'excentricité radiale estimé.

7. Procédé (300, 400, 500) selon la revendication 6, dans lequel le paramètre de tolérance d'excentricité radiale estimé est déterminé pour un point de mesure discrète (100), situé sur une voie centrale (120) du pneu (20).

8. Procédé (300, 400, 500) selon la revendication 1, dans lequel le procédé (300, 400, 500) comprend les opérations, consistant à:

   obtenir un paramètre d'uniformité radiale estimé mesuré pour le point de mesure discrète (100); et

   comparer le paramètre d'uniformité radiale estimé mesuré pour le point de mesure discrète (100) avec le paramètre d'uniformité radiale estimé, déterminé en utilisant le modèle pour évaluer une rigidité du pneu (20).

9. Procédé (300, 400, 500) selon la revendication 1, dans lequel le procédé (300, 400, 500) comprend l'opération consistant à générer, avec le dispositif informatique (606), le modèle qui corrèle la tolérance d'excentricité radiale et la variation de la force radiale du pneu (20).

10. Procédé (300, 400, 500) selon la revendication 9, dans lequel le modèle comprend un modèle de convolution, qui corrèle un paramètre de variation de force radiale estimé à un point de mesure discrète (100) avec un paramètre de tolérance d'excentricité radiale mesuré pour un ou plusieurs points de mesure, proches du point de mesure discrète (100).

11. Procédé (300, 400, 500) selon la revendication 10, dans lequel l'opération, consistant à générer le modèle (300, 400, 500) comprend les opérations, consistant à:

obtenir des données de tolérance d'excentricité radiale mesurées pour un ou plusieurs pneus (20) dans un jeu de pneus d'essai;
obtenir des données de variation de force radiale mesurées pour les un ou plusieurs pneus (20) dans le jeu de pneus d'essai;
modéliser le paramètre de variation de force radiale estimé au point de mesure discrète (100), au titre d'une somme pondérée du paramètre de tolérance d'excentricité radiale mesuré à un ou plusieurs points de mesure (110), proches du point de mesure discrète (100); et
estimer, avec un dispositif informatique (606), un ou plusieurs coefficients pour la somme pondérée en fonction des données de tolérance d'excentricité radiale mesurées et des données de variation de force radiale mesurées.

12. Procédé (300, 400, 500) selon la revendication 11, dans lequel les un ou plusieurs coefficients sont estimés en utilisant une analyse de régression ou une analyse de programmation.

13. Procédé (300, 400, 500) selon la revendication 9, dans lequel le modèle comprend un modèle de déconvolution, qui corrèle un paramètre de tolérance d'excentricité radiale estimé à un point de mesure discrète (100) avec un paramètre de variation de force radiale mesuré pour un ou plusieurs points de mesure (110), proches du point de mesure discrète (100).

14. Procédé (300, 400, 500) selon la revendication 13, dans lequel l'opération, consistant à générer le modèle, comprend les opérations, consistant à:

obtenir des données de tolérance d'excentricité radiale mesurées pour un ou plusieurs pneus (20) dans un jeu de pneus d'essais;
obtenir des données de variation de force radiale mesurées pour les un ou plusieurs pneus (20) dans le jeu de pneus d'essai;
modéliser le paramètre de tolérance d'excentricité radiale estimé au point de mesure discrète (100) en tant que somme pondérée du paramètre de variation de force radiale mesuré à un ou plusieurs points de mesure (110), proches du point de mesure discrète (100); et
estimer un ou plusieurs coefficients pour la somme pondérée en fonction des données de tolérance d'excentricité radiale mesurées et des données de variation de force radiale mesurées.

15. Système d'estimation d'un paramètre d'uniformité d'un pneu (20), le système comprenant:

une machine de mesure (604), configurée pour acquérir un paramètre d'uniformité radiale mesuré pour une pluralité de points de mesure (110) autour d'un pneu (20);
un dispositif informatique (606), couplé à ladite machine de mesure (604), le dispositif informatique (606) étant configuré pour accéder à un modèle qui corrèle la tolérance d'excentricité radiale du pneu (20) avec la variation de la force radiale du pneu (20) et pour déterminer un paramètre d'uniformité radiale estimé pour au moins un point de mesure discrète (100) du pneu (20), en utilisant le modèle, le modèle corrélant un paramètre d'uniformité radiale estimé à un point de mesure discrète (100) en tant que somme pondérée du paramètre d'uniformité radiale mesuré au point de mesure discrète (100) et un ou plusieurs points de mesure sélectionnés (110), proches du point de mesure discrète (100);
dans lequel le paramètre d'uniformité radiale estimé pour le au moins un point de mesure discrète (100) est déterminé en fonction au moins en partie du paramètre d'uniformité radiale mesuré pour un ou plusieurs points de mesure (110), proches du point de mesure discrète (100) sur le pneu (20).

FIG.1

FIG.2

FIG.3

FIG.4

FIG.5

400

OBTAIN A MEASURED RADIAL RUN OUT PARAMETER FOR A PLURALITY OF MEASUREMENT POINTS ABOUT THE TIRE ~402

ACCESS CONVOLUTION MODEL CORRELATING RADIAL RUN OUT OF THE TIRE WITH RADIAL FORCE VARIATION OF THE TIRE ~404

DETERMINE AN ESTIMATED RADIAL FORCE VARIATION PARAMETER FOR ONE OR MORE DISCRETE MEASUREMENT POINTS USING THE MODEL ~406

408

SORT OR GRADE TIRE BASED ON ESTIMATED RADIAL FORCE VARIATION

OBTAIN A MEASURED RADIAL FORCE VARIATION PARAMETER FOR THE ONE OR MORE DISCRETE MEASUREMENT POINTS ~412

410

MODIFY TIRE MANUFACTURE BASED ON ESTIMATED RADIAL FORCE VARIATION

COMPARE MEASURED RADIAL FORCE VARIATION WITH ESTIMATED RADIAL FORCE VARIATION TO ASSESS TIRE STIFFNESS ~414

FIG.6

500

```
┌─────────────────────────────────────────┐
│ OBTAIN A MEASURED RADIAL FORCE VARIATION │
│ PARAMETER FOR A PLURALITY OF MEASUREMENT │──502
│     POINTS ABOUT THE TIRE                │
└─────────────────────────────────────────┘
                    │
                    ▼
┌─────────────────────────────────────────┐
│ ACCESS DECONVOLUTION MODEL CORRELATING   │
│ RADIAL RUN OUT OF THE TIRE WITH RADIAL   │──504
│     FORCE VARIATION OF THE TIRE          │
└─────────────────────────────────────────┘
                    │
                    ▼
┌─────────────────────────────────────────┐
│ DETERMINE AN ESTIMATED RADIAL RUN OUT    │
│    PARAMETER FOR ONE OR MORE             │──506
│ DISCRETE MEASUREMENT POINTS USING THE    │
│              MODEL                       │
└─────────────────────────────────────────┘
```

508                                              510

```
┌──────────────────────┐      ┌──────────────────────┐
│ SORT OR GRADE TIRE   │      │ MODIFY TIRE MANUFACTURE│
│ BASED ON ESTIMATED   │      │ BASED ON ESTIMATED    │
│   RADIAL RUN OUT     │      │   RADIAL RUN OUT      │
└──────────────────────┘      └──────────────────────┘
```

# FIG.7

FIG.8

EP 2 979 074 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1435516 A
- WO 2011159272 A
- WO 2012074527 A